(19) Europäisches Patentamt
European Patent Office
Office européen des brevets

(11) **EP 2 834 877 B1**

(12) **FASCICULE DE BREVET EUROPEEN**

(45) Date de publication et mention de la délivrance du brevet:
**25.05.2016 Bulletin 2016/21**

(21) Numéro de dépôt: **13714915.9**

(22) Date de dépôt: **08.04.2013**

(51) Int Cl.:
*H01M 10/48* (2006.01)    *H01M 10/0525* (2010.01)
*H01M 10/42* (2006.01)

(86) Numéro de dépôt international:
**PCT/EP2013/057269**

(87) Numéro de publication internationale:
**WO 2013/150157 (10.10.2013 Gazette 2013/41)**

(54) **BATTERIE D'ACCUMULATEURS PROTEGEE CONTRE LES ARCS ELECTRIQUES**

BATTERIE MIT LICHTBOGENSCHUTZ

BATTERY PROTECTED AGAINST ELECTRIC ARCS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.04.2012 FR 1253203**

(43) Date de publication de la demande:
**11.02.2015 Bulletin 2015/07**

(73) Titulaire: **Commissariat à l'Énergie Atomique et aux Énergies Alternatives
75015 Paris (FR)**

(72) Inventeurs:
• **DAHMANI, Jawad
38100 Grenoble (FR)**
• **CATTIN, Viviane
38120 Saint Egreve (FR)**
• **PERICHON, Pierre
38500 Voiron (FR)**

(74) Mandataire: **GIE Innovation Competence Group
310, avenue Berthelot
69372 Lyon Cedex 08 (FR)**

(56) Documents cités:
**JP-A- 2010 101 706    US-A- 4 442 700
US-A1- 2011 267 721**

• **Joseph Luis: "Detection of Electric Arcs in 42-volts Automotive Systems", , 21 décembre 2003 (2003-12-21), pages 1-139, XP055047305, Extrait de l'Internet: URL:http://dspace.mit.edu/bitstream/handle /1721.1/29676/53833851.pdf?sequence=1 [extrait le 2012-12-10]**

EP 2 834 877 B1

**Description**

L'invention concerne le stockage d'énergie électrique, par exemple dans des batteries d'accumulateurs électrochimiques. Celles-ci peuvent par exemple être utilisées dans le domaine des transports électriques et hybrides ou les systèmes embarqués. De telles batteries peuvent également être utilisées comme alimentations de secours.

Les véhicules hybrides combustion/électrique ou électriques incluent notamment des batteries de forte puissance. De telles batteries sont utilisées pour entraîner un moteur électrique à courant alternatif par l'intermédiaire d'un onduleur. Les niveaux de tension nécessaires pour de tels moteurs atteignent plusieurs centaines de Volts, typiquement de l'ordre de 400 Volts. De telles batteries comportent également une forte capacité afin de favoriser l'autonomie du véhicule en mode électrique.

Pour obtenir de fortes puissances et capacités, on place plusieurs groupes d'accumulateurs en série. Pour faciliter la fabrication et la manipulation de la batterie, les accumulateurs sont généralement regroupés dans plusieurs modules connectés en série. Le nombre d'étages dans un module et le nombre d'accumulateurs en parallèle dans chaque étage varient en fonction de la tension, du courant et de la capacité souhaités pour la batterie. Les accumulateurs électrochimiques utilisés pour de tels véhicules sont généralement du type lithium ion pour leur capacité à stocker une énergie importante avec un poids et un volume contenus. Les technologies de batterie de type Lithium ion phosphate de fer LiFePO4 font l'objet d'importants développements du fait d'un niveau de sécurité intrinsèque élevé, au détriment d'une densité de stockage d'énergie un peu en retrait. Un accumulateur électrochimique a habituellement une tension nominale de l'ordre de grandeur suivant :

     3.3 V pour une technologie lithium-ion phosphate de Fer, LiFePO4,
     4.2 V pour une technologie de type lithium-ion à base d'oxyde de cobalt.

Le document 'Detection of Electric Arcsin 42-Volt Automotive Systems' décrit différents procédés de détection d'arcs. Ce document décrit notamment un procédé de détection d'arcs par ultrason. En pratique, ce document décrit que des capteurs acoustiques doivent être répartis à différents endroits du véhicule pour détecter des arcs pour différents emplacements du faisceau électrique. Les capteurs acoustiques sont également envisagés pour détecter des arcs pour des interconnexions d'une source électrique, la source et les interconnexions étant protégées dans un boîtier formant donc une séparation avec l'extérieur. Ce document conclut sur l'impossibilité à ce stade d'obtenir une solution de localisation en se basant uniquement sur des capteurs acoustiques, du fait de la sensibilité aux erreurs. Ce document n'apporte pas de solution à la détection des arcs électriques des interconnexions de la source électrique.

Le document US4442700 décrit un dispositif de mesure de l'hygrométrie à l'intérieur d'une batterie. Ce document décrit notamment une batterie munie d'un boîtier de protection, des cellules de stockage d'énergie électrique disposées dans le boîtier et connectées électriquement en série par des éléments d'interconnexion. Des barres de bus servent à connecter des plaques d'une même cellule. De l'electrolyte liquide baigne les plaques à l'intérieur du boîtier. Des capteurs acoustiques sont disposés contre la paroi à l'extérieur du boîtier et sont ainsi protégés contre la corrosion de l'electrolyte. A partir de la mesure des capteurs, le document propose de déterminer l'hygrométrie et l'état de charge de la batterie.

Le document JP2010-101706 décrit une batterie logée dans un boîtier de protection. La batterie est munie d'un transducteur ultrasonore fixé à l'extérieur de la batterie et utilisé pour émettre un signal ultrasonore dans la batterie et pour mesurer la réponse ultrasonore de la batterie. En fonction de la réponse, un circuit détermine la capacité de cette batterie. Cette détermination de capacité est basée sur la diffusion de composés dans l'electrolyte avec l'usure de la batterie, qui modifie la réponse ultrasonore.

Étant données les quantités d'énergie stockées dans des batteries de puissance destinées à la traction de véhicules automobiles, des défaillances de telles batteries peuvent avoir des conséquences considérables.

Un type de défaillance potentielle est l'apparition d'arcs électriques au niveau de la connexion série entre des accumulateurs électrochimiques. Les arcs électriques ont le plus souvent pour origine l'usure, la corrosion, les vibrations ou un choc lié à un accident. Avec une source de tension continue telle qu'une batterie, les arcs électriques restent amorcés aussi longtemps que du courant est appelé par une charge électrique.

Les arcs électriques se manifestent lors de la création d'un espace entre deux conducteurs électriques dans lesquels circule un courant, la conduction électrique se poursuivant à travers cet espace. L'arc comporte deux zones de pied d'arc s'étendant depuis les deux conducteurs électriques respectifs. Ces zones de pieds d'arc présentent généralement une longueur comprise entre 5 et 10 $\mu$m et une température de l'ordre de la température de fusion des deux conducteurs électriques. Cette température est par exemple de l'ordre de 1000°C pour des conducteurs électriques en cuivre. Ces zones de pieds d'arcs sont séparées par un plasma présentant une température par exemple de l'ordre de 10 000°C. Cette température dépend de l'équilibre thermique entre l'apport d'énergie lié au courant et le refroidissement par radiation essentiellement. Plus le courant est important et/ou plus l'arc est court et plus cette température est élevée.

Les arcs électriques induisent un échauffement extrêmement élevé qui peut être à l'origine de la fusion d'une connectique entre les accumulateurs et des matériaux environnants.

Ainsi, si de tels arcs électriques ne sont pas détectés suffisamment tôt, ceux-ci peuvent avoir pour conséquence un départ d'incendie. Par conséquent, il existe un besoin pour la détection d'apparition d'arcs électriques. La détection d'un arc électrique s'avère relativement ardue dans une batterie, les cellules électrochimiques étant généralement logées à demeure dans des boîtiers de protection. La batterie présente une structure complexe avec de nombreuses zones mécaniquement isolées et difficiles d'accès. De plus, une batterie comprend un grand nombre d'interconnexions susceptibles de générer un arc électrique.

Une méthode générique de détection d'arcs est basée sur une mesure de courant et de tension. L'apparition d'un arc électrique induit des perturbations sur la tension et le courant aux bornes de la batterie. Par un traitement de signal approprié de ces mesures, il est possible de détecter l'apparition d'un arc électrique dans certaines applications. Cette solution est cependant inapplicable pour des batteries, puisque les accumulateurs électrochimiques présentent une impédance très faible qui atténue la signature en tension des arcs électriques. Pour pallier ce problème de détection, un grand nombre de capteurs devrait être utilisé, ce qui indurait un coût inapproprié pour le détecteur.

Une autre méthode générique de détection d'arcs repose sur la mesure du rayonnement optique. En présence d'un arc électrique, un rayonnement optique très particulier est émis. Ce rayonnement comporte la superposition d'un spectre continu et d'un spectre discontinu. Le spectre continu est émis durant les collisions des électrons avec les ions ou atomes du plasma. Le spectre discontinu correspond à des photons, de fréquences bien déterminées émis par un atome, un ion ou une molécule qui passe d'un niveau d'énergie à un niveau d'énergie inférieure. Cette solution est cependant inapplicable pour des batteries, puisque le capteur de rayonnement serait incapable de détecter le rayonnement de certaines connexions occultées par un boîtier de protection de forme complexe ou disposées au coeur d'un module et occultées par des accumulateurs électrochimiques.

Une autre méthode de détection d'arcs est utilisée dans des panneaux photovoltaïques. Cette méthode est basée sur la mesure du champ électromagnétique et l'identification d'une signature spécifique. Une telle détection induit un nombre important de fausses alarmes en particulier lorsque le bruit électromagnétique environnant est important. Une telle solution est donc inadaptée à des applications automobiles, soumises à d'importants parasites dans le domaine radiofréquence, notamment du fait de la motorisation électrique. Par ailleurs, une telle détection est fortement affectée par tout écran à la propagation des ondes électromagnétiques, les éléments métalliques tels qu'un carter de batterie ou le châssis du véhicule formant de tels écrans. En outre, une telle détection présente un temps de réponse relativement long.

Une autre méthode de détection d'arcs électriques est utilisée pour les lignes électriques aériennes. On utilise pour cela un détecteur muni d'un capteur acoustique présentant une fréquence de résonance de 40 kHz. Un arc électrique se manifeste en effet généralement pas l'émission d'une onde acoustique dont le spectre inclut une telle fréquence. Le capteur acoustique mesure donc une valeur bien spécifique des perturbations ultrasonores à proximité des lignes électriques. Le capteur acoustique présente une très grande directivité. Le signal fourni par le capteur acoustique est modulé vers des fréquences du spectre audible. Le signal audible est fourni à un opérateur par l'intermédiaire d'écouteurs. L'opérateur détermine la présence d'arcs électriques par l'apparition d'un son audible dans les écouteurs. Un tel détecteur n'est pas applicable à une batterie puisque les accumulateurs électrochimiques sont séparés de l'opérateur par le boîtier de protection.

Ainsi, aucune méthode de détection d'arcs électriques dans une batterie d'accumulateurs électrochimiques de puissance n'est satisfaisante pour une application industrielle.

L'invention vise à résoudre un ou plusieurs de ces inconvénients. L'invention porte ainsi sur une source d'alimentation électrique continue, telle que détaillée dans les revendications annexées.

D'autres caractéristiques et avantages de l'invention ressortiront clairement de la description qui en est faite ci-après, à titre indicatif et nullement limitatif, en référence aux dessins annexés, dans lesquels :

- la figure 1 est une représentation schématique en perspective d'un premier exemple de mise en oeuvre d'une détection d'arc électrique selon l'invention ;
- la figure 2 est une représentation schématique en perspective d'un deuxième exemple de mise en oeuvre d'une détection d'arc électrique selon l'invention ;
- la figure 3 est une représentation schématique d'un module de détection selon une variante de l'invention ;
- la figure 4 est un diagramme illustrant un exemple de réponse temporelle générée par un capteur ultrasonore suite à l'apparition d'un arc électrique ;
- la figure 5 est un diagramme de la réponse en fréquence acoustique de l'air ;
- la figure 6 illustre des diagrammes COR obtenus pour la détection d'arc selon un exemple de l'invention, pour différents niveaux de bruits.

L'invention propose de détecter l'apparition d'arcs électriques dans une source d'alimentation électrique continue comportant une pluralité de dispositifs de stockage d'énergie électrique connectés électriquement en série par l'intermédiaire d'éléments d'interconnexions. Ces dispositifs de stockage sont logés dans un boîtier dans lequel se trouve un milieu de remplissage ayant une impédance acoustique homogène. Ce milieu de remplissage forme une liaison acoustique continue entre ces éléments d'interconnexion et un capteur acoustique ultrasonore.

Une mesure ultrasonore à l'intérieur du boîtier permet à la fois de détecter l'apparition d'arcs dans différents emplacements même masqués à l'intérieur du boîtier, et d'assurer une sensibilité très réduite aux sources de perturbations extérieures, le boîtier assurant une filtration très efficace par rapport à d'éventuels arcs électriques extérieurs du fait du changement de milieu qu'il induit.

La détection des vibrations ultrasonores propagées par le milieu de remplissage est favorisée par rapport à une solution de propagation à travers la connexion électrique ou à travers les éléments structurels, la connexion électrique en série dans la batterie 1 comprenant un grand nombre de discontinuités et une telle propagation s'avérant sensible aux perturbations provenant de l'extérieur.

Par exemple, dans un véhicule automobile, un très grand nombre de composants peuvent générer des arcs électriques durant leur fonctionnement normal (par exemple les clignotants) et ceux-ci doivent donc être discriminés d'un arc électrique apparaissant dans la batterie d'alimentation ou d'un moteur électrique de traction.

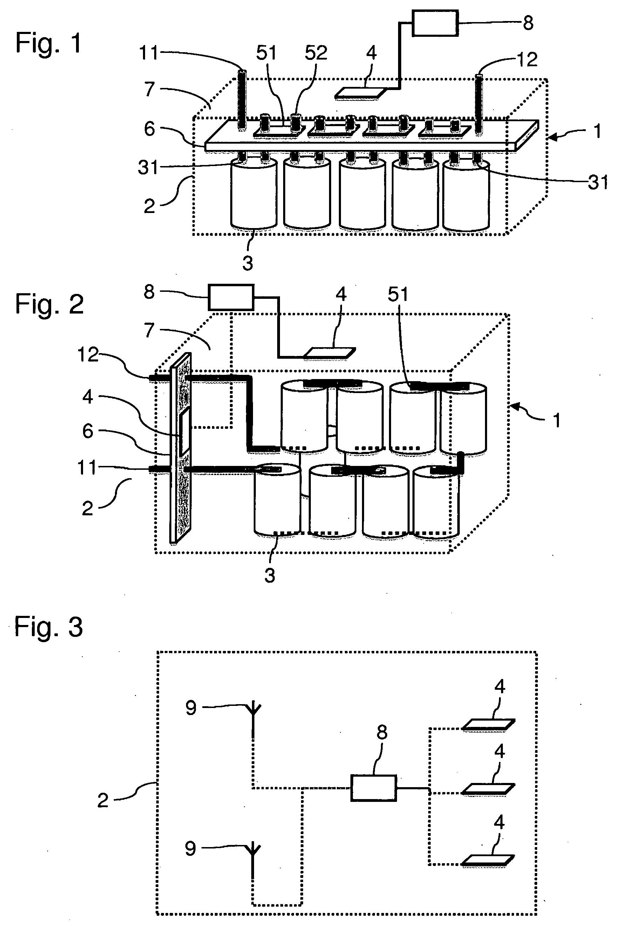

La figure 1 est une représentation schématique en perspective d'un premier exemple de mise en oeuvre de la détection d'un arc électrique dans une batterie 1. La batterie 1 comporte un boîtier de protection 2. Des dispositifs de stockage d'énergie électrique 3 sous la forme d'accumulateurs électrochimiques sont logés à l'intérieur du boîtier 2. Le boîtier de protection 2 protège notamment de façon connue en soit les accumulateurs électrochimiques 3 des poussières, protège l'homme des contacts électriques et protège l'environnement extérieur des conséquences de la destruction éventuelle d'un de ces accumulateurs. Les accumulateurs électrochimiques 3 illustrés sont connectés électriquement en série entre deux bornes 11 et 12 de la batterie 1. La batterie 1 est typiquement une batterie de puissance apte à appliquer une tension au moins égale à 25V, généralement au moins égale à 50 V, et plus fréquemment au moins égale à 100V à ses bornes.

Chaque accumulateur électrochimique 3 comporte deux bornes 31 de polarités opposées. La connexion en série entre les bornes 31 des différents accumulateurs 3 est ici réalisée par l'intermédiaire d'éléments d'interconnexion 51, typiquement sous la forme de lames métalliques. Ces éléments d'interconnexion 51 sont maintenus en contact électrique avec les bornes 31 par l'intermédiaire de vis 52 vissées dans les bornes 31. On peut également envisager un contact électrique entre les éléments d'interconnexion 51 et les bornes 31 réalisé au moyen de soudures ou de connexions élastiques à ressort. La liaison série entre deux accumulateurs 3 présentent une discontinuité de matière du fait de l'utilisation de ces interconnexions 51. Les éléments d'interconnexion 51 peuvent être disposés sur un substrat 6. Le substrat 6 peut comporter différents circuits électroniques, par exemple pour la mesure de la tension aux bornes des accumulateurs électrochimiques ou pour la mesure de la température à l'intérieur du boîtier 2.

Un arc électrique naît dans le milieu de remplissage 7 dans lequel les éléments d'interconnexion 51 sont noyés. Du fait de son impédance acoustique homogène et de la liaison acoustique continue qu'il forme entre le capteur 4 et l'élément d'interconnexion confronté à un arc électrique, le milieu de remplissage 7 propage les ondes ultrasonores jusqu'à ce capteur 4.

Le milieu de remplissage 7 est un isolant électrique. Le milieu de remplissage 7 comporte avantageusement une impédance acoustique très différente de l'impédance acoustique des parois du boîtier de protection 2. Du fait de cette différence d'impédance, lorsqu'une onde acoustique ultrasonore générée par un arc électrique se propage dans le milieu de remplissage 7 et rencontre une paroi du boîtier 2, l'énergie acoustique est essentiellement réfléchie par la paroi et continue à se propager dans le milieu de remplissage 7. De même, l'onde acoustique est essentiellement réfléchie lorsqu'elle rencontre d'autres composants dans le boîtier 2. Les échos de l'onde générée présentent ainsi une amplitude suffisamment élevée pour être détectée par un capteur 4. Par conséquent, la vibration ultrasonore générée par un arc électrique se propage jusqu'à une distance importante à l'intérieur du boîtier 2 et jusqu'au capteur 4, ce qui permet de détecter des arcs électriques même pour les interconnexions isolées ou masquées par d'autres composants. La proportion de l'énergie acoustique absorbée par la paroi du boîtier 2 transmise à travers la paroi du boîtier 2 est ainsi réduite. En outre, les perturbations acoustiques ultrasonores extérieures au boîtier 2 ne sont transmises au milieu de remplissage 7 qu'avec une très grande atténuation. La précision de la détection d'un arc électrique à l'intérieur du boîtier 2 est ainsi optimisée.

Le milieu de remplissage 7 peut typiquement être de l'air, un gaz inerte ou un matériau à changement de phase tel qu'un matériau organique à changement de phase. Un matériau à changement de phase est typiquement utilisé pour réduire la vitesse de propagation d'un réchauffement dans la batterie 1, face à une augmentation brutale d'une température localisée à l'intérieur du boîtier 2.

Le plus souvent, même pour une batterie 1 munie d'un circuit de refroidissement liquide pour ses accumulateurs électrochimiques, les bornes des accumulateurs et les éléments d'interconnexion sont placés dans de l'air, l'air assurant une liaison continue entre ces différents éléments d'interconnexion. Une telle configuration est le plus souvent adoptée pour des exigences d'assemblage des accumulateurs électrochimiques de la batterie 3.

Le boîtier de protection 2 est typiquement réalisé en matériaux synthétiques, par exemple en matériaux polymères mais peut également être réalisé en métal (aluminium moulé par exemple). Le boîtier de protection 2 est avantageusement étanche, afin d'isoler le capteur 4 de perturbations acoustiques extérieures.

Le capteur acoustique 4 est avantageusement configuré pour mesurer des ultrasons avec une bande passante s'étendant entre 20 kHz et 150 kHz. De nombreux capteurs ultrasonores industriels présentent un pic de détection à environ 40KHz. A 40kHz, l'onde ultrasonore est peu atténuée dans l'air et reste assez directive. Pour permettre de détecter l'apparition d'arcs électriques en de nombreux emplacements différents, le capteur acoustique 4 comporte avantageusement un lobe de réception principal présentant une ouverture au moins égale à 90°, de préférence au moins égale à 100°, et préférentiellement au moins égale à 120°. Le capteur commercialisé sous la référence commerciale R15-alpha par la société EPA s'est notamment avéré satisfaisant dans des tests réalisés.

En particulier lorsque le milieu de remplissage 7 est de l'air ou un gaz, le capteur acoustique 4 est avantageusement choisi dans le groupe comprenant les capteurs à membrane, les capteurs de type MEMS et les capteurs capacitifs.

Le capteur acoustique 4 est ici fixé à l'intérieur du boîtier 2 contre une paroi de ce boîtier. La partie du capteur 4 effectuant la mesure de l'onde ultrasonore est en contact avec le milieu de remplissage 7 et avantageusement espacée du boîtier 2. Le boîtier 2 est avantageusement étanche acoustiquement. Une discontinuité de milieu de propagation est formée par le boîtier 2 entre l'extérieur et l'intérieur de ce boîtier. On peut cependant envisager de placer ce capteur 4 en tout endroit approprié, par exemple sur le substrat 6.

Un circuit électronique de traitement 8 est connecté au capteur acoustique 4 pour assurer la détection de l'apparition d'un arc électrique. Des méthodes de détection d'arc électrique en fonction de la réponse du capteur acoustique 4 seront détaillées par la suite.

La figure 2 est une représentation schématique en perspective d'un deuxième exemple de mise en oeuvre de la détection d'un arc électrique dans une batterie 1. Le boîtier 2 et le milieu de remplissage 7 sont sensiblement identiques à ceux mentionnés en référence à la figure 1. Dans cet exemple, les accumulateurs électrochimiques 3 sont connectés électriquement en série entre deux bornes 11 et 12 de la batterie 1. Les accumulateurs 3 sont connectés en série par l'intermédiaire d'éléments d'interconnexion 51. Les extrémités d'un élément d'interconnexion 51 sont soudées sur des bornes respectives de deux accumulateurs 3.

Plusieurs capteurs ultrasonores sont disposés à l'intérieur du boîtier 2. Les différents capteurs ultrasonores 4 sont répartis de façon appropriée à l'intérieur du boîtier 2. Certains capteurs ultrasonores peuvent être fixés sur les parois du boîtier 2, d'autres capteurs peuvent être disposés contre des parois du boîtier 2. Les capteurs 4 sont en liaison acoustique avec les éléments d'interconnexion 51.

Sur la figure 2, on a illustré les interconnexions entre une même branche d'accumulateurs 3 connectés en série. La batterie 1 peut bien entendu comporter d'autres branches connectées électriquement en parallèle de la branche illustrée.

En utilisant une pluralité de capteurs 4, on peut avantageusement déterminer une position de l'arc électrique généré. Le circuit électronique de traitement 8 peut par exemple comparer les réponses fournies par différents capteurs 4. En fonction de l'amplitude et du décalage temporel entre ces réponses (par exemple le décalage temporel entre les pics de mesure mesurés par les différents capteurs 4), on peut déterminer la distance séparant les différents capteurs 4 de l'arc électrique. Une technique de triangulation permet notamment de localiser le lieu de l'arc électrique.

L'utilisation d'une pluralité de capteurs 4 permet également de fiabiliser la détection d'un arc dans un environnement fortement encombré à l'intérieur du boîtier 2.

La figure 3 illustre un exemple d'une batterie 1 comportant un perfectionnement pour la détection des arcs électriques. La batterie 1 inclut au moins un capteur électromagnétique 9. La batterie 1 illustrée ici inclut deux capteurs électromagnétiques 9 disposés à différents emplacements à l'intérieur du boîtier 2. Les capteurs électromagnétiques 9 sont connectés au circuit électronique de traitement 8.

Du fait de l'énorme différence de vitesse de propagation entre l'onde électromagnétique et l'onde vibratoire générées par l'apparition d'un arc électrique, le circuit de traitement 8 est apte à déterminer l'instant d'apparition de l'arc électrique à partir du signal mesuré par un capteur 9 et peut ensuite déterminer la distance entre l'arc électrique et un capteur 4 à partir du décalage temporel entre la détection de l'arc par ce capteur 4 et la détection par un capteur 9. Du fait de la plus grande fiabilité des mesures effectuées par le capteur 4 ultrasonore, le circuit 8 détermine avantageusement l'apparition d'un arc électrique sur la base des mesures des capteurs ultrasonores 4 et utilise les mesures des capteurs électromagnétiques 9 uniquement pour optimiser la localisation de l'arc électrique.

La combinaison d'une détection par un capteur électromagnétique et par un capteur ultrasonore permet en outre de réduire la probabilité de détection d'une fausse alarme.

Le capteur électromagnétique peut aussi permettre de déclencher l'acquisition des vibrations ultrasonores.

La signature vibratoire d'un arc électrique est un signal transitoire très large bande dans les ultrasons. Cette onde vibratoire est omnidirectionnelle, ce qui facilite la détection de l'arc électrique même isolé ou masqué par d'autres composants.

L'onde vibratoire se propage en subissant des phénomènes de réflexion, réfraction, diffusion et absorption. Ceux-ci contribuent à l'atténuation progressive de l'onde qui se manifeste par une décroissance de l'amplitude des oscillations sonores avec la distance. L'atténuation globale de la vibration ultrasonore est exponentielle et correspond globalement à la relation ci-dessous :

$$I = I_0 * e^{-\alpha x}$$

L'intensité, notée I, est définie comme la puissance de l'onde ultrasonore par unité de surface, avec α le coefficient d'atténuation et x l'épaisseur traversée.

L'onde subit une absorption: une partie de l'énergie ultrasonore est transformée en chaleur. Ce phénomène provoque un échauffement du milieu dans lequel l'onde se propage. La diffusion a lieu si les ultrasons rencontrent un objet ou une ouverture de dimension inférieure ou de l'ordre de leur longueur d'onde. La diffusion se manifeste par la propagation du faisceau selon une direction autre que celle d'incidence. Lorsqu'une onde ultrasonore rencontre, sous incidence normale, une interface entre deux milieux d'impédances acoustiques différentes, elle subit une réflexion et une transmission dont le rapport de puissance est fonction des impédances des deux milieux selon la relation ci-dessous :

$$R = \frac{E_{ref}}{E_{incid}} = \left(\frac{Z_1 - Z_2}{Z_1 + Z_2}\right)^2$$

Les calculs menés à l'interface air/accumulateur montrent que la quasi-totalité de l'onde ultrasonore est réfléchie (99.9 %) avec les paramètres ci-dessous :

l'impédance de l'air $Z^{air} = \rho^{air} * c^{air} = 440 kg.m^{-2}.s^{-1}$
l'impédance d'un accumulateur $Z^{ele} = \rho^{ele} * C^{ele} = 4,5*10^6 kg.m^{-2}.S^{-1}$

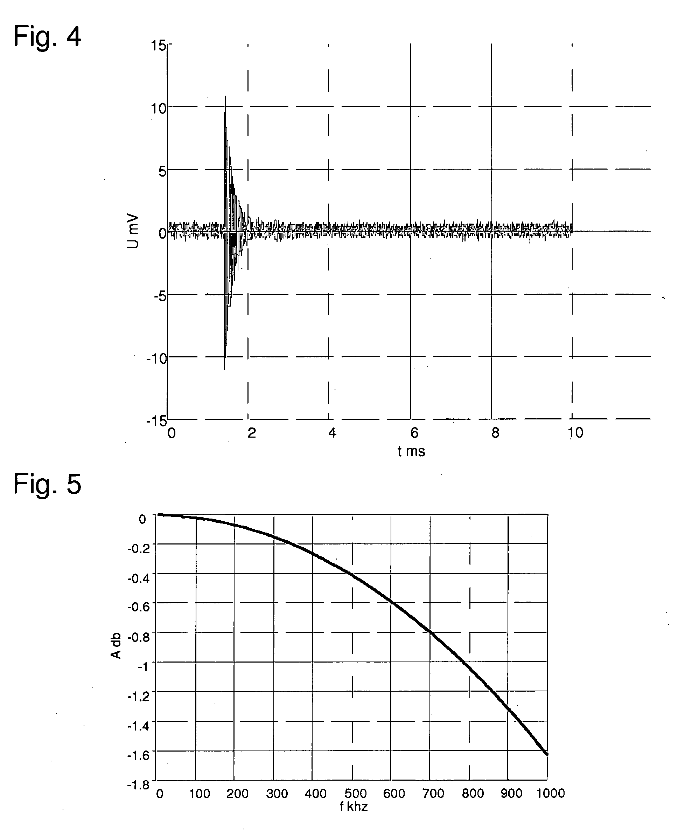

La figure 4 illustre un exemple de réponse temporelle en tension d'un capteur ultrasonore 4 suite à l'apparition d'un arc électrique. L'instant 0 correspond à l'apparition de l'arc électrique. Le capteur 4 étant distant de l'arc électrique généré, le capteur 4 ne détecte pas immédiatement la vibration ultrasonore induite par l'arc électrique. Le capteur 4 mesure alors un bruit de fond. Lorsque l'onde ultrasonore se propageant dans le milieu de remplissage 7 atteint le capteur 4, celui-ci mesure un pic d'onde acoustique suivi d'un ensemble d'oscillations amorties, avec une décroissance exponentielle.

Différentes méthodes de détection des arcs électriques sont possibles sur la base des réponses mesurées par les capteurs ultrasonores.

Comme les arcs électriques peuvent induire différentes formes de réponse ultrasonores, on peut prévoir de mémoriser au préalable différents profils de réponse des capteurs 4 correspondant à des arcs électriques. Les profils de réponse mémorisés peuvent alors être comparés aux réponses mesurées par les capteurs 4.

Différents modèles d'arcs électriques peuvent être mémorisés, avec différentes amplitudes et/ou différentes vitesses de décroissance.

La signature ultrasonore d'un arc électrique peut être modélisée par un filtre autorégressif de type ARMA. D'autres méthodes comme celles consistant à utiliser un filtre adapté ou un réseau de neurones peuvent également être utilisées.

Pour la modélisation d'un arc électrique par un filtre régressif ARMA, on utilise une base de données de mesures de capteurs ultrasonores correspondant à différents types d'arcs électriques. Pour chacun de ces arcs, on détermine l'ordre du filtre ARMA dont la réponse impulsionnelle s'approche au mieux du signal mesuré correspondant. Pour apprécier l'adaptation du filtre ARMA modélisant l'arc, on évalue l'erreur quadratique moyenne du modèle par rapport au signal mesuré.

Lorsque le capteur 4 fournit une mesure au circuit 8, celui-ci calcule par exemple une inter corrélation du signal mesuré avec les différents modèles de type filtre ARMA mémorisés. Pour cela, on applique une fenêtre glissante au signal mesuré et on calcule un coefficient de corrélation normalisé entre le modèle et le signal mesuré pour chaque fenêtre. Le calcul d'un coefficient de corrélation normalisé coeff peut être le suivant :

$$coeff = \frac{corr(stest, s\,mod)}{\|stest\|_2 . \|s\,mod\|_2}$$

Avec stest le signal mesuré pour une fenêtre et smod le signal du modèle.

Si la valeur du coefficient coeff dépasse un seuil prédéterminé (correspondant à un seuil de sensibilité à une fausse alarme), le circuit 8 détermine la présence d'un arc électrique.

Des tests ont été réalisés sur la base d'un tel calcul de corrélation entre un modèle ARMA et un signal mesuré. Ces tests ont permis de déterminer que même avec une isolation médiocre par rapport à différentes sources ultrasonores, l'utilisation de la corrélation avec des modèles d'arc était très discriminante et limitait fortement les risques de fausse alarme. Du fait de la bonne connaissance préalable du profil de la vibration ultrasonore, l'utilisation de la corrélation donne d'excellents résultats pour éliminer des détections de fausses alarmes. Par ailleurs, une telle détection basée sur la corrélation est peu sensible à la superposition d'un signal transmis directement au capteur 4 par le milieu de remplissage 7 avec des échos parvenant au capteur 4.

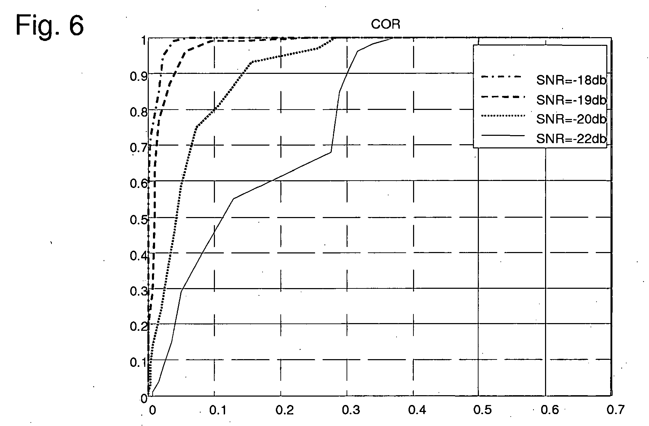

La fiabilité de la détection est notamment illustrée par les courbes COR de la figure 6, simulées en fonction de différents niveaux de bruit (probabilité de fausse détection en abscisse, probabilité de détection en ordonnée).

Eventuellement, d'autres sources de bruit présentant des signatures proches (un clignotant de véhicule automobile génère des arcs électriques périodiques) pourraient être discriminées en cas de mauvaise isolation de l'intérieur de la batterie, en identifiant par exemple des caractéristiques distinctives de la source de perturbations. Un clignotant est par exemple identifiable du fait de la périodicité des arcs électriques qu'il génère ou du fait d'une moindre amplitude des vibrations.

Pour améliorer la fiabilité de la détection de l'arc, on peut réaliser une modulation programmée de la charge électrique connectée à la batterie. Une telle modulation se traduisant par une modulation sur l'émission acoustique éventuelle de l'arc (phénomène physique connu sous le nom d'arc chantant), une analyse de corrélation entre la modulation du courant appelé sur la batterie et la modulation mesurée sur la vibration acoustique est possible. La modulation de courant peut être définie par un circuit de supervision de la batterie 1, ce circuit de supervision communiquant avec le circuit électronique de traitement 8 pour lui fournir des paramètres de la modulation de courant appliquée.

Une batterie peut être organisée en une pluralité de modules interconnectés électriquement en série et/ou en parallèle, chaque module incluant une pluralité d'accumulateurs électrochimiques interconnectés électriquement. En individualisant la détection d'un arc électrique pour chaque module, on peut prévoir d'isoler un module défaillant afin d'assurer la continuité de service de la batterie. À cet effet, chaque module peut être muni d'un dispositif de sécurisation tel que décrit dans la demande de brevet FR1155349. Les autres modules connectés en série avec le module défaillant peuvent ainsi continuer à alimenter les bornes de la batterie.

Bien que l'invention ait été décrite en référence à une batterie d'accumulateurs électrochimiques, l'invention s'applique également à d'autres sources d'alimentation électrique continue incluant de multiples dispositifs de stockage d'énergie connectés en série par l'intermédiaire d'éléments d'interconnexion.

**Revendications**

1. Source d'alimentation électrique continue (1), comprenant :

   - un boîtier de protection (2) ;
   - des dispositifs de stockage d'énergie électrique (3) disposés dans le boîtier de protection, ces dispositifs de stockage étant connectés électriquement en série par l'intermédiaire d'éléments d'interconnexion (51) ;
   - un capteur acoustique (4) configuré pour mesurer des ultrasons ;
   - un milieu de remplissage (7) disposé dans le boîtier ;

   **caractérisée en ce que** le milieu de remplissage présente une impédance acoustique homogène et forme une liaison acoustique continue entre lesdits éléments d'interconnexion et le capteur acoustique.

2. Source d'alimentation électrique continue (1) selon la revendication 1, comprenant en outre un circuit électronique (8) configuré pour détecter l'apparition d'un arc électrique en fonction des ultrasons mesurés par le capteur acoustique (4).

3. Source d'alimentation électrique continue (1), selon la revendication 2, comprenant plusieurs capteurs acoustiques (4) configurés pour mesurer des ultrasons et espacés les uns des autres, le milieu de remplissage (7) formant une liaison acoustique continue entre les éléments d'interconnexion et les capteurs acoustiques répartis, et le circuit électronique (8) étant configuré pour déterminer la position de l'arc électrique en fonction des instants respectifs de mesure d'un pic ultrasonore par chacun desdits capteurs.

4. Source d'alimentation électrique continue selon la revendication 2 ou 3, comprenant en outre un capteur électromagnétique (9) disposé dans le boîtier (2), le circuit électronique (8) étant configuré pour confirmer une détection d'apparition d'un arc électrique en fonction du signal électromagnétique mesuré par le capteur électromagnétique (9).

5. Source d'alimentation électrique continue selon la revendication 4, dans laquelle le circuit électronique (8) est configuré pour déterminer la position de l'arc électrique en fonction de la durée entre un pic ultrasonore mesuré par le capteur ultrasonore (4) et un pic électromagnétique mesuré par le capteur électromagnétique (9).

6. Source d'alimentation continue selon l'une quelconque des revendications 2 à 5, dans laquelle le circuit électronique (8) est configuré pour calculer une intercorrélation entre les ultrasons mesurés et un modèle de vibration générée par un arc électrique, le circuit électronique étant configuré pour détecter l'apparition d'un arc électrique lorsque l'intercorrélation calculée dépasse un seuil.

7. Source d'alimentation électrique continue selon l'une quelconque des revendications 2 à 6, dans laquelle le circuit électronique (8) est configuré pour :

   - commander une modulation prédéfinie de la charge électrique connectée aux bornes de la source d'alimentation ;
   - calculer une intercorrélation entre les ultrasons mesurés et la modulation de charge électrique commandée ;
   - détecter l'apparition d'un arc électrique en fonction de l'intercorrélation calculée.

8. Source d'alimentation électrique continue selon l'une quelconque des revendications précédentes, dans laquelle le capteur acoustique (4) est configuré pour mesurer des ultrasons avec une bande passante s'étendant au moins entre 20 kHz et 150 kHz.

9. Source d'alimentation électrique continue selon l'une quelconque des revendications précédentes, dans laquelle le capteur acoustique est choisi dans le groupe comprenant les capteurs à membrane, le capteur de type MEMS et les capteurs capacitifs.

10. Source d'alimentation électrique continue selon l'une quelconque des revendications précédentes, dans laquelle le capteur acoustique (4) comporte un lobe de réception principal présentant une ouverture au moins égale à 90°.

11. Source d'alimentation électrique continue selon l'une quelconque des revendications précédentes, dans laquelle le boîtier de protection (2) est étanche de façon à isoler le capteur acoustique de perturbations acoustiques extérieures.

12. Source d'alimentation électrique continue selon l'une quelconque des revendications précédentes, dans laquelle le milieu de remplissage (7) est de l'air.

13. Source d'alimentation électrique continue selon l'une quelconque des revendications précédentes, dans laquelle une partie du capteur acoustique effectuant une mesure d'onde ultrasonore est en contact avec le milieu de remplissage.


**Patentansprüche**

1. Kontinuierliche Stromversorgungsquelle (1), die enthält:

   - ein Schutzgehäuse (2);
   - im Schutzgehäuse angeordnete Speichervorrichtungen elektrischer Energie (3), wobei diese Speichervorrichtungen mittels Zwischenverbindungselementen (51) elektrisch in Reihe geschaltet sind;
   - einen akustischen Sensor (4), der konfiguriert ist, Ultraschallwellen zu messen;
   - ein im Gehäuse angeordnetes Füllmedium (7);

   **dadurch gekennzeichnet, dass** das Füllmedium eine homogene akustische Impedanz aufweist und eine kontinuierliche akustische Verbindung zwischen den Zwischenverbindungselementen und dem akustischen Sensor bildet.

2. Kontinuierliche Stromversorgungsquelle (1) nach Anspruch 1, die außerdem einen elektronischen Schaltkreis (8) enthält, der konfiguriert ist, das Auftreten eines Lichtbogens abhängig von den vom akustischen Sensor (4) gemessenen Ultraschallwellen zu erfassen.

3. Kontinuierliche Stromversorgungsquelle (1) nach Anspruch 2, die mehrere akustische Sensoren (4) enthält, die konfiguriert sind, Ultraschallwellen zu messen und voneinander entfernt sind, wobei das Füllmedium (7) eine kontinuierliche akustische Verbindung zwischen den Zwischenverbindungselementen und den verteilten akustischen Sensoren bildet, und der elektronische Schaltkreis (8) konfiguriert ist, die Stellung des Lichtbogens abhängig von den jeweiligen Messzeitpunkten einer Ultraschallspitze durch jeden der Sensoren zu bestimmen.

4. Kontinuierliche Stromversorgungsquelle nach Anspruch 2 oder 3, die außerdem einen im Gehäuse (2) angeordneten elektromagnetischen Sensor (9) enthält, wobei der elektronische Schaltkreis (8) konfiguriert ist, eine Erfassung des Auftretens eines Lichtbogens abhängig von dem vom elektromagnetischen Sensor (9) gemessenen elektromagnetischen Signal zu bestätigen.

5. Kontinuierliche Stromversorgungsquelle nach Anspruch 4, wobei der elektronische Schaltkreis (8) konfiguriert ist, die Stellung des Lichtbogens abhängig von der Dauer zwischen einer vom Ultraschallwellensensor (4) gemessenen Ultraschallspitze und einer vom elektromagnetischen Sensor (9) gemessenen elektromagnetischen Spitze zu bestimmen.

6. Kontinuierliche Stromversorgungsquelle nach einem der Ansprüche 2 bis 5, wobei der elektronische Schaltkreis (8) konfiguriert ist, eine Interkorrelation zwischen den gemessenen Ultraschallwellen und einem von einem Lichtbogen generierten Vibrationsmodell zu berechnen, wobei der elektronische Schaltkreis konfiguriert ist, das Auftreten eines Lichtbogens zu erfassen, wenn die berechnete Interkorrelation eine Schwelle überschreitet.

7. Kontinuierliche Stromversorgungsquelle nach einem der Ansprüche 2 bis 6, wobei der elektronische Schaltkreis (8) konfiguriert ist:

   - eine vordefinierte Modulation der mit den Klemmen der Versorgungsquelle verbundenen elektrischen Last zu steuern;
   - eine Interkorrelation zwischen den gemessenen Ultraschallwellen und der gesteuerten elektrischen Lastmodulation zu berechnen;
   - das Auftreten eines Lichtbogens abhängig von der berechneten Interkorrelation zu erfassen.

**8.** Kontinuierliche Stromversorgungsquelle nach einem der vorhergehenden Ansprüche, wobei der akustische Sensor (4) konfiguriert ist, Ultraschallwellen mit einem Durchlassband zu messen, das sich mindestens zwischen 20 kHz und 150 kHz erstreckt.

**9.** Kontinuierliche Stromversorgungsquelle nach einem der vorhergehenden Ansprüche, wobei der akustische Sensor aus der Gruppe ausgewählt wird, die die Membransensoren, den Sensor von der Art MEMS und die kapazitiven Sensoren enthält.

**10.** Kontinuierliche Stromversorgungsquelle nach einem der vorhergehenden Ansprüche, wobei der akustische Sensor (4) eine Hauptempfangskeule aufweist, die eine Öffnung von mindestens gleich 90° hat.

**11.** Kontinuierliche Stromversorgungsquelle nach einem der vorhergehenden Ansprüche, wobei das Schutzgehäuse (2) dicht ist, um den akustischen Sensor gegenüber äußeren akustischen Störungen zu isolieren.

**12.** Kontinuierliche Stromversorgungsquelle nach einem der vorhergehenden Ansprüche, wobei das Füllmedium (7) Luft ist.

**13.** Kontinuierliche Stromversorgungsquelle nach einem der vorhergehenden Ansprüche, wobei ein Teil des akustischen Sensors, der eine Ultraschallwellenmessung durchführt, mit dem Füllmedium in Kontakt ist.

**Claims**

**1.** DC electrical power supply source (1), comprising:

- a protective housing (2);
- electrical energy storage devices (3) disposed in the protective housing, these storage devices being connected electrically in series by way of interconnection elements (51);
- an acoustic sensor (4) configured to measure ultrasounds;
- a filling medium (7) disposed in the housing; **characterized in that** the filling medium exhibits a homogeneous acoustic impedance and forms a continuous acoustic link between said interconnection elements and the acoustic sensor.

**2.** DC electrical power supply source (1) according to Claim 1, furthermore comprising an electronic circuit (8) configured to detect the occurrence of an electric arc as a function of the ultrasounds measured by the acoustic sensor (4).

**3.** DC electrical power supply source (1) according to Claim 2, comprising several acoustic sensors (4) configured to measure ultrasounds and spaced apart, the filling medium (7) forming a continuous acoustic link between the interconnection elements and the distributed acoustic sensors, and the electronic circuit (8) being configured to determine the position of the electric arc as a function of the respective instants of measurement of an ultrasound spike by each of said sensors.

**4.** DC electrical power supply source according to Claim 2 or 3, furthermore comprising an electromagnetic sensor (9) disposed in the housing (2), the electronic circuit (8) being configured to confirm a detection of occurrence of an electric arc as a function of the electromagnetic signal measured by the electromagnetic sensor (9).

**5.** DC electrical power supply source according to Claim 4, in which the electronic circuit (8) is configured to determine the position of the electric arc as a function of the duration between an ultrasound spike measured by the ultrasound sensor (4) and an electromagnetic spike measured by the electromagnetic sensor (9). 20

**6.** DC power supply source according to any one of Claims 2 to 5, in which the electronic circuit (8) is configured to calculate an intercorrelation between the ultrasounds measured and a model of vibration generated by an electric arc, the electronic circuit being configured to detect the occurrence of an electric arc when the calculated intercorrelation exceeds a threshold.

**7.** DC electrical power supply source according to any one of Claims 2 to 6, in which the electronic circuit (8) is configured to:

- control a predefined modulation of the electric load connected to the terminals of the power supply source;
- calculate an intercorrelation between the measured ultrasounds and the controlled electric load modulation;
- detect the occurrence of an electric arc as a function of the calculated intercorrelation.

**8.** DC electrical power supply source according to any one of the preceding claims, in which the acoustic sensor (4) is configured to measure ultrasounds with a bandwidth extending at least between 20 kHz and 150 kHz.

**9.** DC electrical power supply source according to any one of the preceding claims, in which the acoustic sensor is chosen from the group comprising membrane-based sensors, sensors of MEMS type and capacitive sensors.

10. DC electrical power supply source according to any one of the preceding claims, in which the acoustic sensor (4) comprises a main reception lobe exhibiting an aperture of at least equal to 90°.

11. DC electrical power supply source according to any one of the preceding claims, in which the protective housing (2) is leaktight so as to isolate the acoustic sensor from exterior acoustic disturbances.

12. DC electrical power supply source according to any one of the preceding claims, in which the filling medium (7) is air.

13. DC electrical power supply source according to any one of the preceding claims, in which a part of the acoustic sensor performing an ultrasound wave measurement is in contact with the filling medium.

Fig. 1

Fig. 2

Fig. 3

Fig. 4

Fig. 5

## Fig. 6

COR

SNR=-18db
SNR=-19db
SNR=-20db
SNR=-22db

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4442700 A
- JP 2010101706 A
- FR 1155349